# EUROPÄISCHE PATENTANMELDUNG

(11) **EP 3 130 982 A1**
(43) Veröffentlichungstag der Anmeldung: **15.02.2017**
(21) Anmeldenummer: 16183952.7
(22) Anmeldetag: 12.08.2016
(51) Int. Cl.: G06F 1/18, H05K 5/02, H05K 9/00

(54) **PCMCIA II- SLOT MIT BLECHABSCHIRMUNG**

(30) Priorität: 13.08.2015 DE 102015215440
(71) Anmelder: Hirschmann Car Communication GmbH, 72654 Neckartenzlingen (DE)
(72) Erfinder: Gelman, Alexander, 70736 Fellbach (DE); Böhmert, Roland, 72762 Reutlingen (DE)
(74) Vertreter: Greif, Thomas

(57) **Zusammenfassung**

Kartenaufnahmevorrichtung (10) mit einem flächig gestalteten Basisteil (11), an dem seitlich Führungen (12) zur Aufnahme und Führung einer Benutzerkarte angeordnet sind, wobei zur Kontaktierung der Benutzerkarte eine Steckverbinderleiste vorgesehen ist, dadurch gekennzeichnet, dass seitlich an dem Basisteil (11) zumindest eine Abwinklung (13, 14, 19) angeordnet ist, die von dem Basisteil (11) in entgegengesetzter Richtung, in die die seitlichen Führungen (12) weisen, ausgerichtet ist.

## Beschreibung

### PCMCIA II- Slot mit Blechabschirmung

Die Erfindung betrifft eine Kartenaufnahmevorrichtung, insbesondere einen sogenannten PCMCIA-II-Slot, und ein System mit einer solchen Kartenaufnahmevorrichtung, mit einem flächig gestalteten Basisteil, an dem seitlich Führungen zur Aufnahme und zur Führung einer Benutzerkarte angeordnet sind, wobei zur Kontaktierung der Benutzerkarte eine Steckverbinderleiste vorgesehen ist, gemäß den Merkmalen des jeweiligen Oberbegriffes der unabhängigen Patentansprüche.

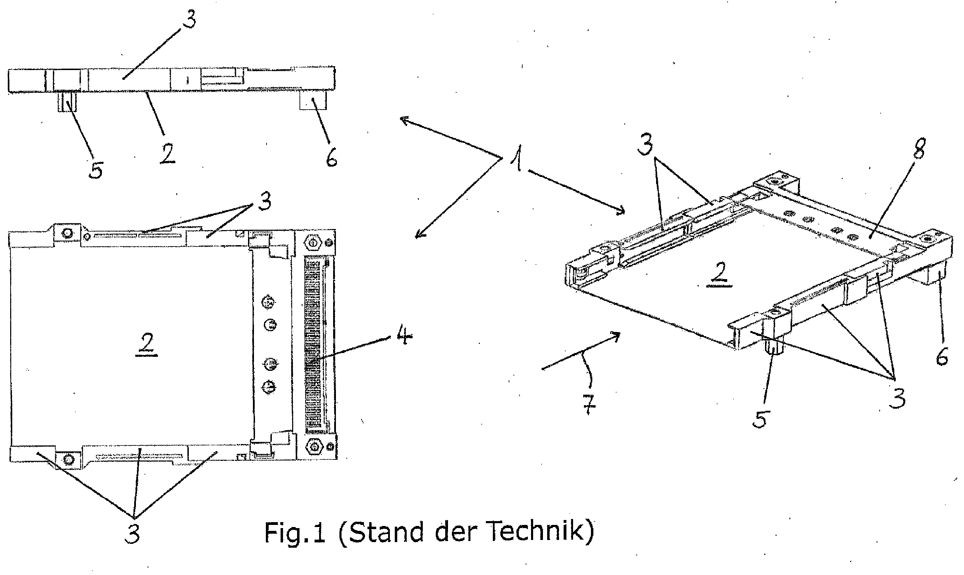

Standardisierte Kartenaufnahmevorrichtungen für elektronische Geräte sind unter dem Kürzel PCMCIA (Personal Computer Memory Card International Association) bekannt. Diese Kartenaufnahmevorrichtungen arbeiten mit PCMCIA-Karten, die besonders stromsparend sind und im laufenden Betrieb gewechselt werden können (sogenanntes Hot-Plug). Da auch alle zur automatischen Konfiguration des Treibers nötigen Eigenschaften der Karte auf dieser abgelegt sind, ist auch Plug and Pfay möglich. Für diese PCMCIA-Karten sind Kartenaufnahmevorrichtungen bekannt, wie sie beispielsweise in Figur 1 gezeigt und mit der Bezugsziffer 1 versehen sind. Solche Kartenaufnahmevorrichtungen 1 bestehen aus einem flächig gestalteten Basisteil 2 und seitlichen Führungen 3, die parallel zueinander verlaufend auf der einen Oberfläche des Basisteiles 2 angeordnet sind. Diese seitlichen Führungen 3 dienen der Aufnahme und Führung einer in der Figur 1 nicht dargestellten Karte. Etwa an dem einen Endbereich (stirnseitig) ist eine Steckverbinderleiste 4 vorhanden, in die korrespondierende Gegensteckverbinder der Karte eingesteckt werden können. Außerdem kann die Kartenaufnahmevorrichtung 1 über diese Steckverbinderleiste 4 mit einem Kabel verbunden werden, um eine Kontaktierung zu einem nicht dargestellten elektronischen Gerät zu schaffen. Zur Montage der Kartenaufnahmevorrichtung 1 an dem Bestimmungsort sind beispielsweise zwei voneinander beabstandete Befestigungsdome vorhanden, wobei auf der der abgewandten Seite, auf der die Befestigungsdome 5 vorhanden sind, ein Distanzhalter 6 vorhanden ist. Mit 7 ist eine Einschubrichtung für die Karte beim Einsetzen in die Kartenaufnahmevorrichtung 1 bezeichnet, wobei das Einsetzen der Karte in Einschubrichtung 7 von einem Anschlagbereich 8, der etwa parallel zu der Steckverbinderleiste 4 vorhanden ist, begrenzt wird.

Oftmals wird die in Figur 1 gezeigte Kartenaufnahmevorrichtung 1 oder vergleichbare Vorrichtungen innerhalb eines elektronischen Gerätes angeordnet, d.h. eingebaut. Dies findet oftmals parallel zu einer Leiterplatte, auf der elektronische Bauteile angeordnet sind, statt. Hierzu wird das Basisteil 2 planparallel in Abstand zu einer nicht gezeigten Leiterplatte über die Befestigungsdome 5 und den Distanzhalter 6 auf der Leiterplatte angeordnet und befestigt. Dabei besteht das Problem, dass dann, wenn es sich bei den elektronischen Bauteilen auf der Leiterplatte um hochfrequente Bauteile, wie zum Beispiel integrierte Schaltkreise zum Verstärken, zum Modulieren oder Demodulieren oder dergleichen handelt, es bei Frequenzen deutlich größer als 1 MHz zu elektronmagnetischen Störeinstrahlungen bzw. Störsignalaussendungen dieser Bauteile kommen kann. Um dies zu verhindern, ist schon daran gedacht worden, diese hochfrequenzkritischen Bauteile sowohl hinsichtlich ihrer Abstrahlungen als auch hinsichtlich der unerwünschten Einstrahlungen von außen mittels Abschirmblechen, Abschirmkäfigen oder dergleichen zu umgeben. Aufgrund des geringen Bauraumes solcher elektronischen Geräte kann allerdings dann in einem solchen Fall beim Vorhandensein von Abschirmkäfigen oder dergleichen eine Kartenaufnahmevorrichtung nicht mehr in diesen Bereich angeordnet werden, da eine zu große Bauhöhe erreicht wird, die entweder nicht zur Verfügung steht oder durch die die gesamte Bauhöhe des elektronischen Gerätes unnötigerweise vergrößert wird. Gleiches gilt für die Fläche, da unter Umständen die Kartenaufnahmevorrichtung an einer Stelle montiert werden muss, die extra hierfür auf der Leiterplatte werden muss und die ansonsten keine oder kaum elektronische Bauteile trägt. Durch diese Maßnahmen vergrößert sich nicht nur die Bauhöhe, sondern auch die längliche und quer dazu ausgerichtete Größe des elektronischen Gerätes in nachteiliger Weise.

Der Erfindung liegt daher die Aufgabe zugrunde, eine Kartenaufnahmevorrichtung der vorstehend beschriebenen Art und ein System, eine solche Kartenaufnahmevorrichtung, bereitzustellen, mit der die eingangs geschilderten Nachteile vermieden werden.

Diese Aufgabe ist durch die Merkmale der beiden unabhängigen Patentansprüche gelöst.

Hinsichtlich der Kartenaufnahmevorrichtung ist erfindungsgemäß vorgesehen, dass seitlich an dem Basisteil zumindest eine Abwinklung angeordnet ist, die von dem Basisteil in entgegengesetzter Richtung, in die die seitlichen Führungen weisen, ausgerichtet ist. Eine solche seitlich an dem Basisteil angeordnete Abwinklung, die zumindest teilweise, aber auch vollständig einmal umlaufen um den Rand des Basisteiles herum vorgesehen sein kann, hat den Vorteil, dass von dem Basisteil zusammen mit der Abwinklung eine Art Abschirmkäfig gebildet wird, durch welchen es gestattet wird, das Basisteil mit der Abwinklung an einer solchen Stelle auf einer Leiterplatte eines elektronischen Gerätes zu positionieren, an der sich hochfrequenzkritische elektronische Bauteile befinden, um diese vor Störeinstrahlungen von außen abzuschirmen bzw. um zu verhindern, dass diese hochfrequenzkritischen Bauteile Störsignale nach außen absenden. Außerdem erleichtert diese erfindungsgemäße Ausgestaltung die Montage des elektronischen Gerätes, weil nicht wie bisher im Stand der Technik zwei Bauteile (Abschirmkäfig und Kartenaufnahmevorrichtung) gehandelt und montiert werden müssen, sondern dass gleichzeitig mit der Montage der Kartenaufnahmevorrichtung auch der Abschirmkäfig gebildet ist und montiert wird.

Verschiedene Ausprägungen der von dem Basisteil abstehenden Abwinklung sind in den Unteransprüchen angegeben, aus denen sich entsprechende Vorteile erzielen lassen. Außerdem wird bezüglich dieser Ausgestaltungen noch im Rahmen der Figurenbeschreibung näher eingegangen.

Hinsichtlich des Systems, aufweisend eine Kartenaufnahmevorrichtung, ist erfindungsgemäß vorgesehen, dass die Kartenaufnahmevorrichtung über die zumindest eine Abwinklung auf einer elektronischen Bauteile tragenden Leiterplatte angeordnet ist. Dadurch steht ein System (insbesondere elektronisches Gerät oder Bestandteil davon) zur Verfügung, bei dem gleichzeitig mit der Montage der Kartenaufnahmevorrichtung die Abschirmung der elektronischen Bauteile, die hochfrequenzkritisch sind und die auf der Leiterplatte angeordnet sind, bewirkt wird.

Im Folgenden wird die Erfindung näher beschrieben und anhand der Figuren erläutert.

Es zeigen:
Figur 1: Eine Kartenaufnahmevorrichtung gemäß dem Stand der Technik (wie einleitend schon beschrieben),
Figuren 2 bis 7: verschiedene Ausgestaltungen einer Kartenaufnahmevorrichtung mit unterschiedlichen Abwinklungen im Seitenbereich.

Figur 1 zeigt eine Kartenaufnahmevorrichtung 1 gemäß dem Stand der Technik, die einleitend der Beschreibung schon beschrieben worden ist. Hierauf wird verwiesen.

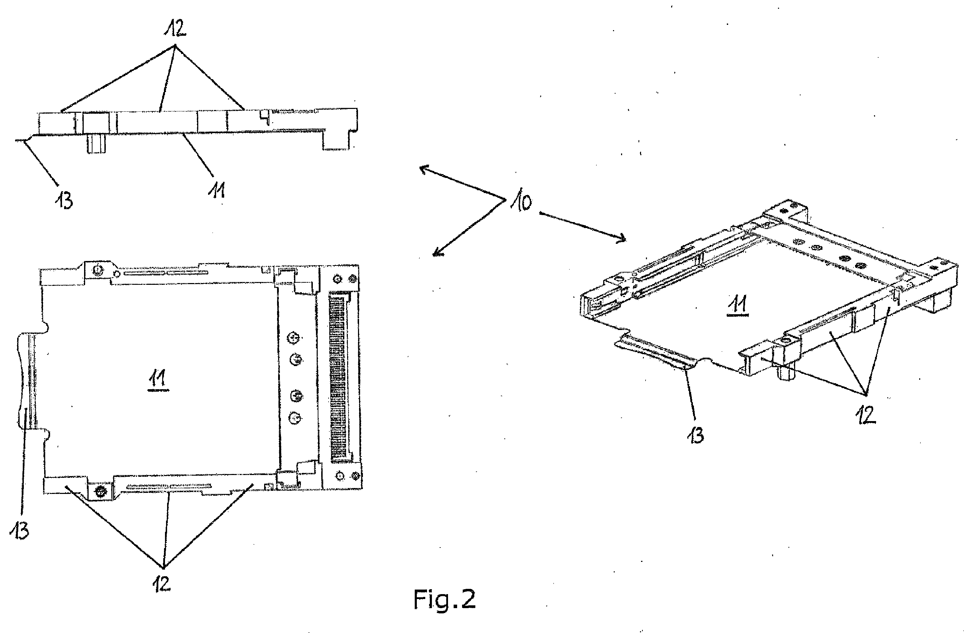

Figur 2 zeigt eine erfindungsgemäße Kartenaufnahmevorrichtung 10, die genauso wie die Kartenaufnahmevorrichtung gemäß dem Stand der Technik ein Basisteil 11 und entsprechende seitliche Führungen 12, die parallel verlaufen und für die Aufnahme der nicht dargestellten Karte ausgebildet sind. Auch die nicht näher bezeichneten Befestigungsdome und der Distanzhalter können in gleicher Weise wie bei der Kartenaufnahmevorrichtung nach dem Stand der Technik oder auch abweichend davon vorhanden sein. Gleiches gilt für die Einschubrichtung und den Anschlagbereich für die Karte, genauso wie für Steckverbinderleiste.

Bei dem Ausführungsbeispiel gemäß Figur 2 ist eine erste Abwinklung 13 an einer Stirnseite (am Beginn des Einschubes für die Karte) vorgesehen. Diese Abwinklung 13 bewirkt zum einen eine Abschirmung für darunterliegende elektronische Bauteile auf einer Leiterplatte (hier noch nicht dargestellt) und/oder es kann ein Leuchtmittel, insbesondere ein Lichtwellenleiter, in diesem Bereich der Abwinklung 13 angeordnet sein, welcher Licht abstrahlt, um dem Benutzer der Kartenaufnahmevorrichtung 10 anzuzeigen, wo sich die Einschuböffnung für die Karte befindet.

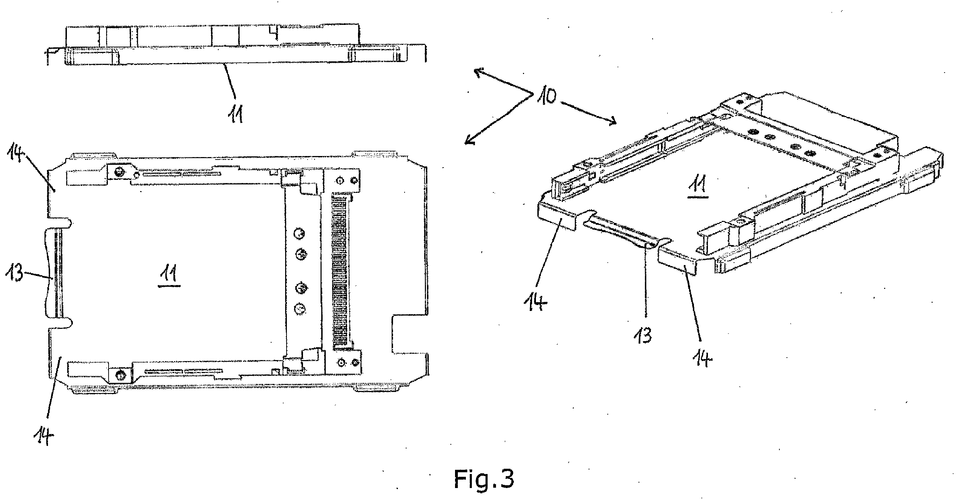

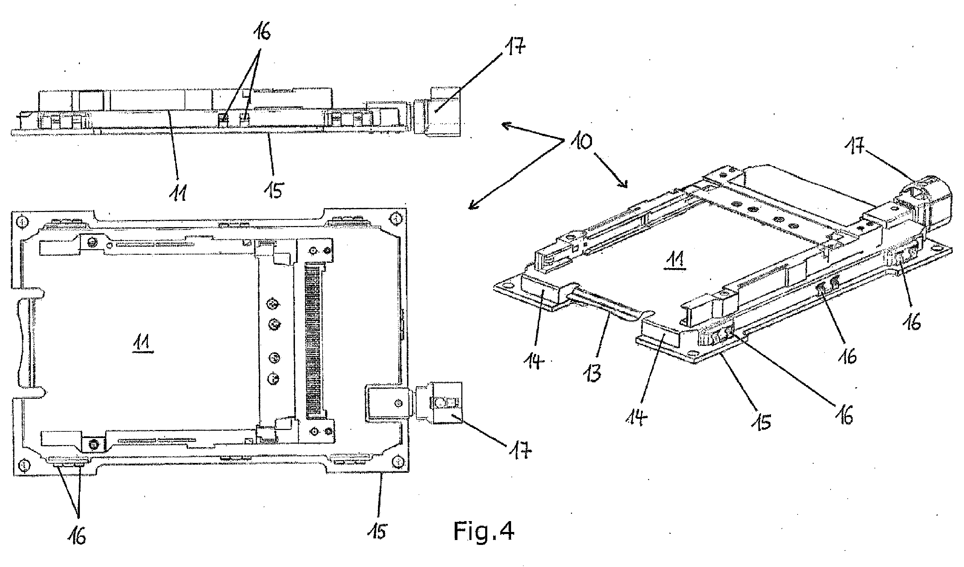

Bei dem Ausführungsbeispiel gemäß Figur 3 ist stirnseitig neben der Abwinklung 13 jeweils eine weitere Abwinklung 14 vorhanden, die in etwa rechtwinklig von dem Basisteil 11 absteht. Die beiden seitlich neben der Abwinklung 13 vorhandenen Abwinklungen 14 haben die gleiche Erstreckung, können sich aber in ihrer Länge auch unterschiedlich erstrecken. Außerdem ist es denkbar, stirnseitig an dem Basisteil 11 eine durchgehende Abwinklung vorzusehen, die rechtwinklig von dem Basisteil 11 absteht und zusätzlich die Abwinklung 13 dazu vorzusehen, das bedeutet, dass sich diese in etwa ausgehend von dem Basisteil 11 von der Einschuböffnung für die Karte nach außen erstreckt. Diese Erstreckung kann in der gleichen Ebene oder abweichend davon gestaltet sein, in der sich das Basisteil 11 befindet. Figur 4 zeigt ein weiteres Ausführungsbeispiel der Kartenaufnahmevorrichtung 10 mit weiteren Elementen. Zum einen ist eine Leiterplatte, auf der die Kartenaufnahmevorrichtung 10 befestigt wird, mit 15 bezeichnet. Die Leiterplatte 15 trägt nicht näher dargestellte elektronische Bauteile, die sich unterhalb des Basisteiles 11 befinden. Mit 16 sind Befestigungsklammern bezeichnet, mit denen die Kartenaufnahmevorrichtung 10 an der Leiterplatte 15 festgelegt wird. In diesem Ausführungsbeispiel sind an den beiden Längsseiten jeweils 3 Befestigungsklammern 16 vorhanden, wobei diese auch stirnseitig oder nur stirnseitig und in anderer Anzahl als 3 vorhanden sein können.

Mit 17 ist ein Steckverbinder der Kartenaufnahmevorrichtung 10 bezeichnet, über den Signale, Stromversorgung oder dergleichen zu den elektronischen Bauteilen auf der Leiterplatte 15 und von dieser weg erfolgen kann. In diesem Ausführungsbeispiel weist das Basisteil 11 bei Betrachtung der Figur 4 (links unten) rechts von der Steckverbinderleiste eine Aussparung für den Steckverbinder 17 auf. Das bedeutet, dass das Gehäuse des Steckverbinders 17 keinen elektrischen Kontakt zu dem Basisteil 11 bzw. zu der gesamten Kartenaufnahmevorrichtung 10 aufweist. Auch hier sind wieder eine Abwinklung 13 und rechts und links davon jeweils eine Abwinklung 14 vorhanden, wobei im Bereich der gezeigten drei Befestigungsklammern 16 auch seitliche Abwinklungen vorhanden sind.

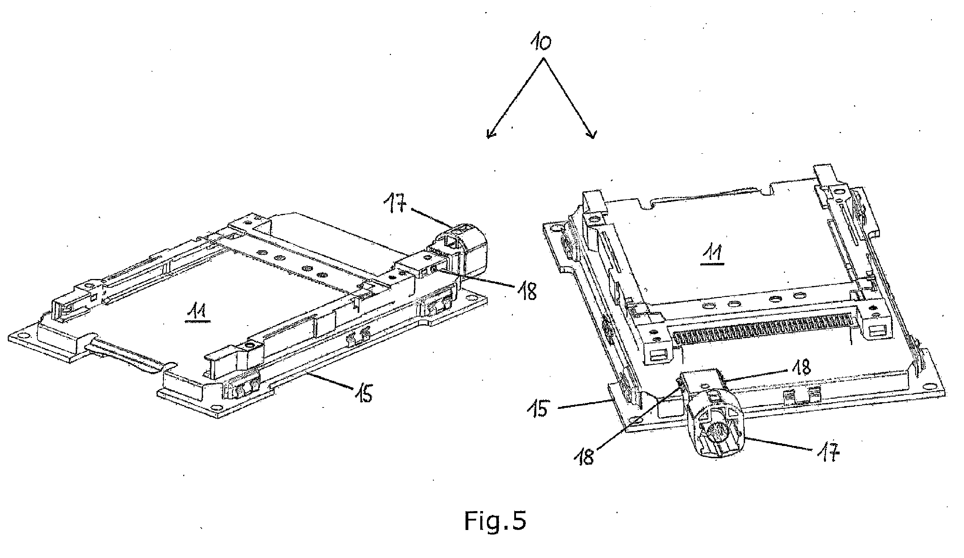

Figur 5 zeigt ein vergleichbares Ausführungsbeispiel, wie es in Figur 4 gezeigt ist. Jedoch ist hier der Unterschied gegeben, dass das Gehäuse des Steckverbinders 17 über ein Kontaktelement 18 mit dem Basisteil 11 der Kartenaufnahmevorrichtung 10 verbunden ist. Durch diese elektrische Kontaktierung, die voraussetzt, dass das Gehäuse des Steckverbinders 17 genauso wie das Basisteil 11 aus einem metallischen Werkstoff sind, erfolgt eine durchgehende Abschirmung nicht nur der elektronischen Bauteilen auf der Leiterplatte 15 unterhalb des Basisteiles 11, sondern auch in Steckrichtung des Steckverbinders 17. Das Kontaktelement 18 kann ein separates Bauteil sein, wie zum Beispiel eine Kontaktklammer. Es ist auch denkbar, den elektrischen Kontakt zwischen Basisteil 11 und Gehäuse des Steckverbinders 17 durch stoffschlüssige Verbindungen wie zum Beispiel Löten oder Verkleben mit einem elektrisch leitfähigen Kleber zu realisieren.

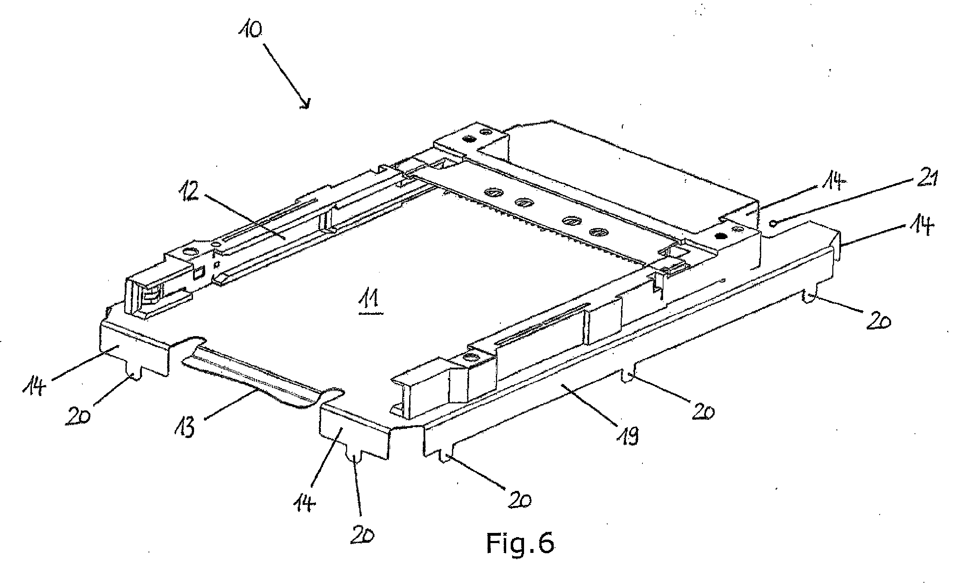

In Figur 6 ist in Alleindarstellung noch einmal die Kartenaufnahmevorrichtung 10 gezeigt, wobei hier die seitlichen Abwinklungen an dem Basisteil 11 mit der Bezugsziffer 19 versehen sind. Außerdem ist hier die Variante gegenüber den bisherigen Figuren gezeigt, dass zumindest eine Abwinklung, vorzugsweise die stirnseitigen Abwinklungen 14 und die seitlichen Abwinklungen 19, mit abstehenden Kontaktfahnen 20 versehen sind. Mit diesen Kontaktfahnen 20 werden die Abwinklungen durch entsprechende Löcher in der Leiterplatte geführt. Dies kann zum einen ausreichen, um die Kartenaufnahmevorrichtung 10 auf der Leiterplatte 15 festzulegen. In besonders vorteilhafter Weise werden die Enden der Kontaktfahnen 20 auf der Unterseite der Leiterplatte 15 mit dort vorhandenen Leiterbahnen oder Leiterpunkten stoffschlüssig verbunden, insbesondere verlötet. Dadurch wird die Kartenaufnahmevorrichtung 10 nicht nur dauerhaft auf der Leiterplatte 15 festgelegt, sondern es wird dadurch auch die gewünschte Abschirmung der elektronischen Bauteile auf der Leiterplatte 15 realisiert, da die stirnseitigen Abwinklungen 14 zusammen mit den seitlichen Abwinklungen 19 und dem Basisteil 11 eine Art Abschirmkäfig (auch als Abschirmgehäuse bezeichnet) bilden. In Figur 6 ist außerdem erkennbar, dass das Basisteil 11 eine Ausnehmung 21 für die Aufnahme des Gehäuses des Steckverbinders 17 aufweist (wie schon in Bezug auf Figur 4 und 5 geschildert). Außerdem kann in diesem Bereich ebenfalls eine stirnseitige Abwinklung 14 vorhanden sein.

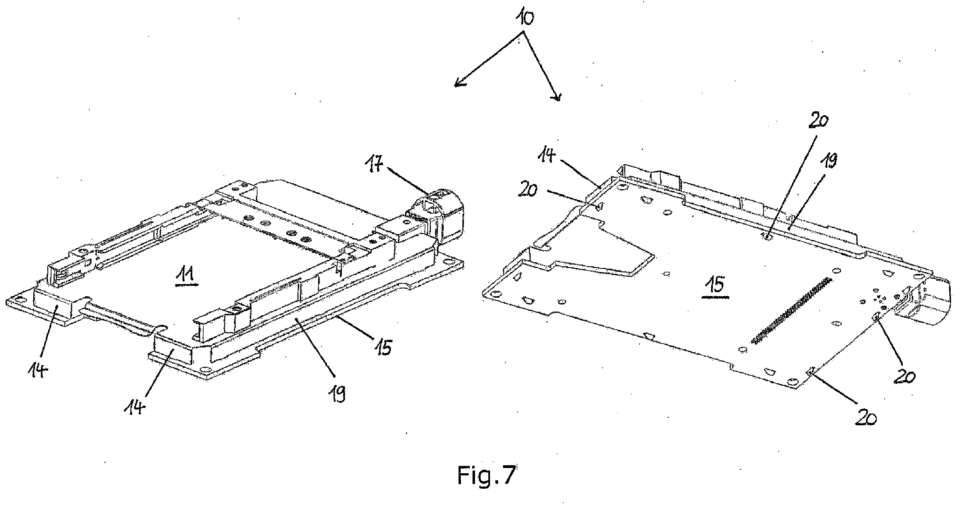

Figur 7 zeigt neben der montierten Kartenaufnahmevorrichtung 10 auf der Leiterplatte 15 noch einmal, wie die stirnseitigen Abwinklungen 14 und die seitlichen Abwinklungen 19 zusammen mit dem Basisteil 11 ein Abschirmgehäuse bilden (linke Darstellung der Figur 7).

Die rechte Darstellung der Figur 7 zeigt die Unterseite der Leiterplatte 15, wobei sehr gut erkennbar ist, dass die Kontaktfahnen 20 der Abwinklungen 14, 19 durch entsprechende Öffnungen in der Leiterplatte 15 hindurch ragen. Diese können zur einfachen mechanischen Festlegung der Kartenaufnahmevorrichtung 10 zum Beispiel an der Unterseite der Leiterplatte 15 umgebogen oder mit dieser verklebt werden. Zur Erzielung der gewünschten Abschirmwirkung werden diese auf der Unterseite der Leiterplatte 15 mit entsprechenden Leiterbahnen, Leiterpunkten oder dergleichen verlötet, elektrisch leitend verklebt oder dergleichen. Auch beim Umbiegen einer Kontaktfahne 20 kann es zu einem Kontakt zu einer solchen Leiterbahn oder dergleichen kommen, sodass keine weiteren Maßnahmen zur stirnschlüssigen Verbindung zwischen Kontaktfahne 20 und Leiterbahn auf der Unterseite der Leiterplatte 15 erforderlich sind.

Es sei abschließend darauf hingewiesen, dass die in den vorangegangenen Figuren gezeigten und beschriebenen Abwinklungen 13, 14 und 19 für die jeweiligen Ausführungsbeispiele beispielhaft sind und andere Erstreckungen in Längsrichtung und/oder Querrichtung dazu aufweisen können. Während in den Ausführungsbeispielen an den Eckbereichen des Basisteiles 11 keine Abwinklung vorhanden ist, kann auch dort durchgehend eine Abwinklung vorhanden sein, die von dem stirnseitigen in den seitlichen Bereich ohne Unterbrechung durchgeht. Außerdem können die seitlichen Abwinklungen 19, die in den Ausführungsbeispielen durchgehend gestaltet sind, Unterbrechungen aufweisen. Je nach Frequenzen, die abgeschirmt werden sollen, können Unterbrechungen vorhanden sein, die trotzdem bewirken, dass entweder Störstrahlungen nicht von innen nach außen oder von außen nach innen aus dem Abschirmgehäuse bzw. in das Abschirmgehäuse hineingelangen können.

### Bezugszeichenliste

- 1.: Kartenaufnahmevorrichtung
- 2.: Basisteil
- 3.: Seitliche Führung
- 4.: Steckverbinderleiste
- 5.: Befestigungsdom
- 6.: Distanzhalter
- 7.: Einschubrichtung
- 8.: Anschlagbereich

- 10.: Kartenaufnahmevorrichtung
- 11.: Basisteil
- 12.: Seitliche Führung
- 13.: Abwinklung (für Lichtwellenleiter)
- 14.: Abwinklung (stirnseitig)
- 15.: Leiterplatte
- 16.: Befestigungsklammer
- 17.: Steckverbinder
- 18.: Kontaktelement
- 19.: Abwinklung (seitlich)
- 20.: Kontaktfahne
- 21.: Ausnehmung

## Patentansprüche

1. Kartenaufnahmevorrichtung (10) mit einem flächig gestalteten Basisteil (11), an dem seitlich Führungen (12) zur Aufnahme und Führung einer Benutzerkarte angeordnet sind, wobei zur Kontaktierung der Benutzerkarte eine Steckverbinderleiste vorgesehen ist, **dadurch gekennzeichnet, dass** seitlich an dem Basisteil (11) zumindest eine Abwinklung (13, 14, 19) angeordnet ist, die von dem Basisteil (11) in entgegengesetzter Richtung, in die die seitlichen Führungen (12) weisen, ausgerichtet ist.

2. Kartenaufnahmevorrichtung (10) nach Anspruch 1, **dadurch gekennzeichnet, dass** die zumindest eine Abwinklung (13, 14) stirnseitig in dem Bereich, in dem die Benutzerkarte in die seitlichen Führungen (12) eingesetzt wird, an dem Basisteil (11) angeordnet ist.

3. Kartenaufnahmevorrichtung (10) nach Anspruch 1 oder 2, **dadurch gekennzeichnet, dass** die zumindest eine Abwicklung (19) parallel zu den seitlichen Führungen (12) an dem Basisteil (11) angeordnet ist.

4. Kartenaufnahmevorrichtung (10) nach Anspruch 1, **dadurch gekennzeichnet, dass** an der zumindest einen Abwinklung (13, 14, 19) zumindest eine Kontaktfahne (20) vorgesehen ist.

5. Kartenaufnahmevorrichtung (10) nach einem der vorhergehenden Ansprüche, **dadurch gekennzeichnet, dass** zumindest eine Befestigungsklammer (16) für die Festlegung der Kartenaufnahmevorrichtung (10) an ihrem Bestimmungsort vorgesehen ist.

6. Kartenaufnahmevorrichtung (10) nach einem der vorhergehenden Ansprüche, **dadurch gekennzeichnet, dass** zumindest eine Steckverbindung (17) vorgesehen ist.

7. Kartenaufnahmevorrichtung (10) nach Anspruch 6, **dadurch gekennzeichnet, dass** zumindest ein Kontaktelement (18) für die Kontaktierung des Basisteiles (11) mit der Steckverbindung (17) vorgesehen ist.

8. System, aufweisend eine Kartenaufnahmevorrichtung (10) nach einem der vorhergehenden Ansprüche, wobei die Kartenaufnahmevorrichtung (10) über die zumindest eine Abwinklung (13, 14, 19) auf einer elektronische Bauteile tragenden Leiterplatte (15) angeordnet ist.
